# EUROPEAN PATENT APPLICATION

(11) **EP 2 755 239 A1**
(43) Date of publication of application: **16.07.2014**
(21) Application number: 12767502.3
(22) Date of filing: 02.04.2012
(51) Int. Cl.: H01L 29/786, G02F 1/1368, H01L 21/336, H01L 29/861

(54) **SEMICONDUCTOR DEVICE AND DISPLAY DEVICE**

(30) Priority: 08.04.2011 JP 2011086192
(71) Applicant: Sharp Kabushiki Kaisha, Osaka-shi, Osaka 545-8522 (JP)
(72) Inventor: HARA Yoshihito, Osaka-shi Osaka 545-8522 (JP); NAKATA Yukinobu, Osaka-shi Osaka 545-8522 (JP)
(74) Representative: Müller - Hoffmann & Partner
(86) International application number: PCT/JP2012/058867
(87) International publication number: WO 2012/137711

(57) **Abstract**

A semiconductor device (**100**) according to the present invention includes a diode element (**10**). The diode element (**10**) includes: a first electrode (**3**) made of the same electrically conductive film as a gate electrode of a thin film transistor; an oxide semiconductor layer (**5**); and a second electrode (**6**) and a third electrode (**7**) being made of the same electrically conductive film as a source electrode of the thin film transistor and being in contact with the oxide semiconductor layer (**5**). The oxide semiconductor layer (**5**) includes offset regions (**19**) respectively between the first electrode (**3**) and the second electrode (**6**) and between the first electrode (**3**) and the third electrode (**7**).

## Description

### TECHNICAL FIELD

The present invention relates to a semiconductor device having a thin film transistor (TFT), and a display device including such a semiconductor device.

### BACKGROUND ART

In recent years, there is vigorous development of TFTs (oxide semiconductor TFTs) in which an oxide semiconductor layer containing indium (In), zinc (Zn), gallium (Ga), or the like is used (e.g. Patent Documents 1 to 3). Since oxide semiconductor TFTs have high mobility characteristics, the display quality of a liquid crystal display device having oxide semiconductor TFTs is expected to be improved, for example.

On the other hand, the fabrication process of a semiconductor device includes steps which are liable to static electricity. Static electricity may induce changes in characteristics or electrostatic discharge failures, thus resulting in a problem in that the production yield of semiconductor devices having the TFTs may be deteriorated. Deterioration in production yield caused by static electricity that occurs is particularly a problem in the TFT substrate (semiconductor device) of a liquid crystal display device.

Therefore, TFT substrates having various means for preventing electrostatic damage have been proposed (e.g. Patent Document 4). Patent Document 4 discloses a TFT substrate in which diode rings are provided for preventing electrostatic discharge failures.

### CITATION LIST

### PATENT LITERATURE

[Patent Document 1] Japanese Laid-Open Patent Publication No. 2003-298062
[Patent Document 2] Japanese Laid-Open Patent Publication No. 2009-253204
[Patent Document 3] Japanese Laid-Open Patent Publication No. 2008-166716
[Patent Document 4] Japanese Laid-Open Patent Publication No. 11-271722

### SUMMARY OF INVENTION

### TECHNICAL PROBLEM

However, the inventors have found that, even if the diode rings for static electricity prevention disclosed in Patent Document 4 are adopted in a semiconductor device having oxide semiconductor TFTs, the oxide semiconductor layer has a small resistance value near the voltage at which they are driven, thus making the diode rings insufficient for static electricity prevention. This problem is common to methods of producing any semiconductor device which includes oxide semiconductor TFTs with a high mobility on an insulative substrate, and which includes diode rings for preventing static electricity in both directions.

The present invention has been made in view of the above problems, and an objective thereof is to provide a semiconductor device having an oxide semiconductor TFT in which electrostatic damage is prevented, and a display device having such a semiconductor device.

### SOLUTION TO PROBLEM

A semiconductor device according to an embodiment of the present invention is a semiconductor device comprising: an insulative substrate; a plurality of lines formed on the insulative substrate; a plurality of thin film transistors; and a plurality of diode elements each electrically connecting two of the plurality of lines to each other, wherein, the plurality of diode elements each include a first electrode made of a same electrically conductive film as gate electrodes of the thin film transistors, an oxide semiconductor layer formed on the first electrode, and a second electrode and a third electrode made of a same electrically conductive film as source electrodes of the thin film transistors, the second electrode and the third electrode being in contact with the oxide semiconductor layer; and the oxide semiconductor layer has offset regions respectively between the first electrode and the second electrode and between the first electrode and the third electrode, the offset regions not overlapping the first electrode when viewed from a normal direction of the insulative substrate.

In one embodiment, the offset regions overlap neither the first, second, nor third electrode when viewed from the normal direction of the insulative substrate.

In one embodiment, a width of the offset regions along a direction which is parallel to a channel direction is not less than 3 µm and not more than 5 µm.

In one embodiment, the plurality of diode elements are in parallel electrical connection, the diode elements being in mutually opposite directions.

In one embodiment, the oxide semiconductor layer contains at least one of In, Ga, and Zn.

In one embodiment, the plurality of lines include a plurality of source lines and a plurality of gate lines; and the plurality of diode elements include at least one of: a diode element electrically connecting two source lines to each other; and a diode element electrically connecting two gate lines to each other.

In one embodiment, the plurality of lines further include a plurality of storage capacitor lines, a common electrode line, or a plurality of test signal lines; and the plurality of diode elements include: a diode element electrically connecting two source lines to each other; a diode element electrically connecting two gate lines to each other; a diode element electrically connecting a gate line and a storage capacitor line to each other; a diode element electrically connecting a source line and a storage capacitor line to each other; a diode element electrically connecting a storage capacitor line and the common electrode line to each other; a diode element electrically connecting a gate line and the common electrode line to each other; a diode element electrically connecting a source line and the common electrode line to each other; or a diode element electrically connecting two test signal lines to each other.

A display device according to an embodiment of the present invention comprises the above semiconductor device.

### ADVANTAGEOUS EFFECTS OF INVENTION

According to the present invention, there is provided a semiconductor device having an oxide semiconductor TFT in which electrostatic damage is prevented, and a display device having such a semiconductor device.

### BRIEF DESCRIPTION OF DRAWINGS

[FIG. **1**] **(a)** is an equivalent circuit diagram of a semiconductor device **100** according to an embodiment of the present invention; and **(b)** is a graph showing voltage-current characteristics of a diode element **10**.
[FIG. **2**] **(a)** is a schematic plan view of a semiconductor device **100** having diode elements **10**; and **(b)** is a schematic cross-sectional view along line **I-I'** in **(a)**.
[FIG. **3**] A graph describing electrical characteristics of a diode element **10**.
[FIG. **4**] **(a)** to **(e)** are diagrams describing production steps for a diode element **10**.
[FIG. **5**] **(a)** to **(e)** are diagrams describing production steps for a pixel TFT.
[FIG. **6**] An equivalent circuit diagram describing test signal lines.

### DESCRIPTION OF EMBODIMENTS

Hereinafter, with reference to the drawings, a production method for a semiconductor device according to an embodiment of the present invention and the construction of a semiconductor device which is produced by that production method (which herein is a TFT substrate for a liquid crystal display device) will be described. The TFT substrate in the present embodiment encompasses TFT substrates of various display devices (e.g., liquid crystal display devices and EL display devices).

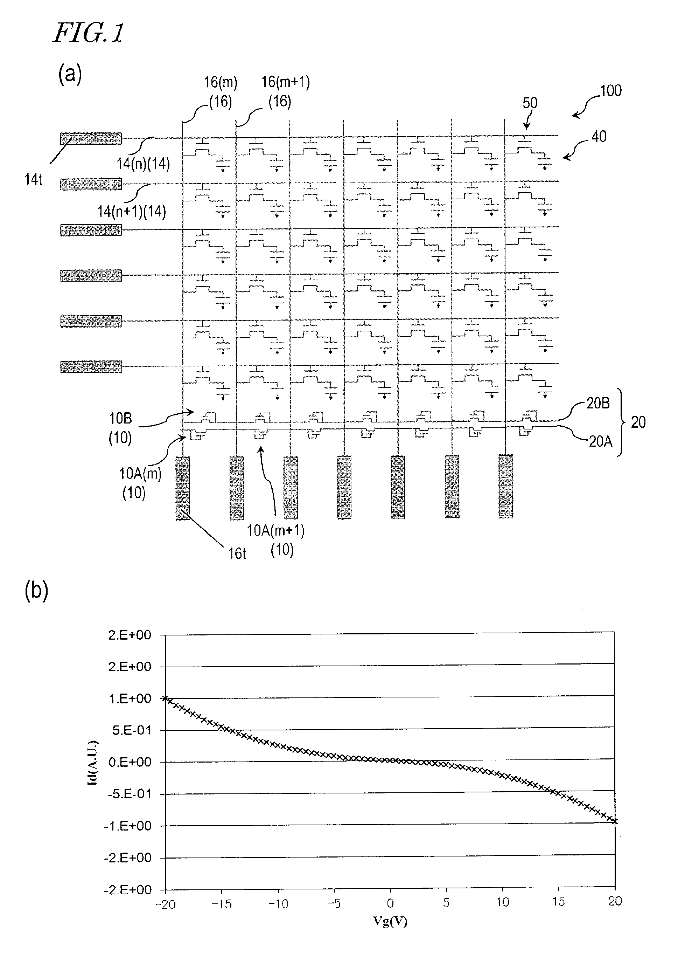

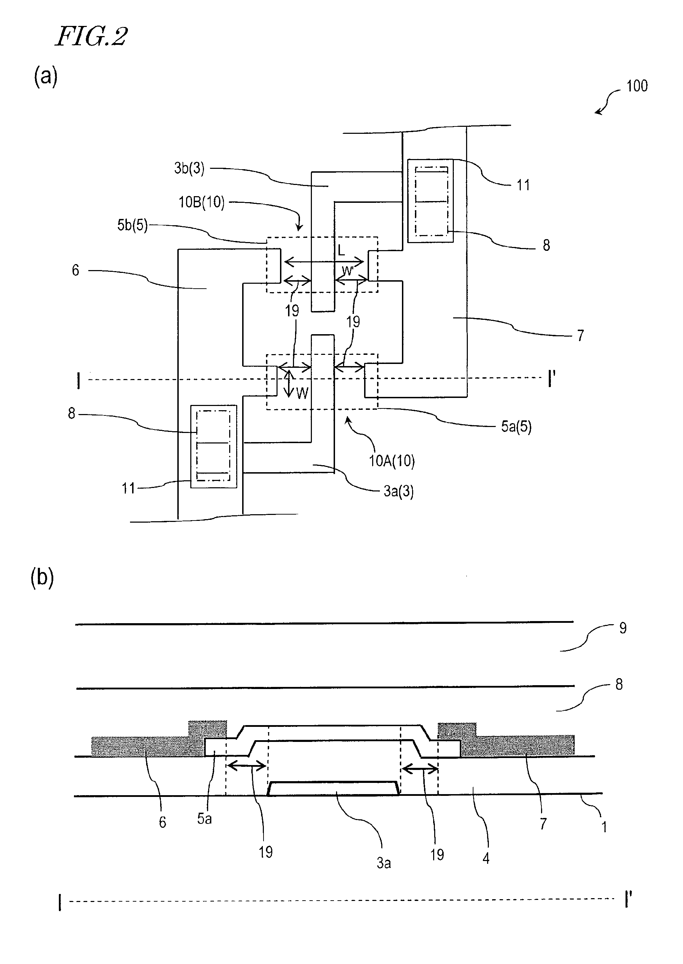

Hereinafter, with reference to FIG. **1** and FIG. **2**, a semiconductor device **100** according to an embodiment of the present invention will be described. FIG. **1(a)** is an equivalent circuit diagram of the semiconductor device **100,** and FIG. **1(b)** is a graph showing voltage (V)-current (I) characteristics of a diode element **10**. FIG. **1(a)** also shows liquid crystal capacitors **40**.

As shown in FIG. **1(a)**, the semiconductor device **100** includes a plurality of gate lines **14** which are disposed in parallel to one another, a plurality of source lines **16** which are orthogonal to the gate lines **14**, pixel electrodes (not shown) each provided in a rectangular region that is surrounded by a gate line **14** and a source line **16**, and thin film transistors (which may also be referred to as pixel TFTs) **50** which are disposed near the intersections between gate lines **14** and source lines **16**. The gate lines **14** and the source lines **16** are electrically connected to the thin film transistors **50**. The gate lines **14** are electrically connected to gate terminals **14t**, whereas the source lines **16** are electrically connected to source terminals **16t**. The gate terminals **14t** and the source terminals **16t** are each electrically connected to an external wiring line (not shown). Each thin film transistor **50** is electrically connected to a pixel electrode and functions as a switching element which applies a voltage to a liquid crystal capacitor (pixel capacitor) **40** of the respective pixel. The liquid crystal capacitor **40** is composed of a pair of electrodes and a liquid crystal layer, where the electrode that is connected to a drain electrode of the pixel TFT is the pixel electrode and the other is a counter electrode. The counter electrode is formed on a counter substrate which opposes the TFT substrate via the liquid crystal layer. Note that, in the case of a liquid crystal display device of the IPS (In-Plane Switching) mode or the FFS (Fringe Field Switching) mode, no counter electrode is formed on the counter substrate.

Between two adjacent source lines (e.g., the source lines **16(m)** and **16(m+1))**, diode elements **10A** and **10B** for short-circuit rings are formed, which have an oxide semiconductor layer that is made of the same oxide semiconductor film as the oxide semiconductor layer of the thin film transistors **50**. The diode elements **10A** and **10B** illustrated herein have a structure in which the source electrode and the gate electrode of a TFT are short-circuited, also referred to as a "TFT-type diode".

The diode elements **10A** and the diode elements **10B** allow currents to flow in mutually opposite directions. For example, the diode element **10A(m)** allows a current to flow from the source line **16(m)** to the source line **16(m+1)**, whereas the diode element **10B(m)** allows a current to flow from the source line **16(m+1)** to the source line **16(m)**. As is illustrated herein, by providing diode elements **10A** and **10B** in parallel connection to every two adjacent source lines, a short-circuit ring **20A** composed of the diode elements **10A** and a short-circuit ring **20B** composed of the diode elements **10B** are created, such that the short-circuit ring **20A** and the short-circuit ring **20B** constitute a short-circuit ring **20**. The short-circuit ring **20** allows a current to flow (i.e., charge to diffuse) in both directions. The diode elements **10A** and **10B** may be disposed between a gate line **14 (n)** and a gate line **14(n+1)** to electrically connect the gate line **14(n)** and the gate line **14(n+1)**.

Moreover, the semiconductor device **100** may further include a plurality of storage capacitor lines, a common electrode line, or a plurality of test signal lines. In this case, the diode elements **10A** and **10B** may be disposed between a gate line **14** and a storage capacitor line, between a source line and a storage capacitor line, between a storage capacitor line and the common electrode line, between a gate line and the common electrode line, between a source line and the common electrode line, or between two test signal lines, so as to electrically connect these lines. As used herein, the common electrode line is, in the case where the semiconductor device **100** is used for a liquid crystal display device, for example, a line which is electrically connected to a counter electrode that is formed on the substrate opposing the semiconductor device **100**. Furthermore, a test signal line is a line with which the electrical characteristics of a pixel TFT are tested. Details of test signal lines are disclosed in Japanese Laid-Open Patent Publication No. 2005-122209 and the specification of USP No. 6,624,857. The entire disclosure of Japanese Laid-Open Patent Publication No. 2005-122209 and the specification of USP No. 6,624,857 is incorporated herein by reference.

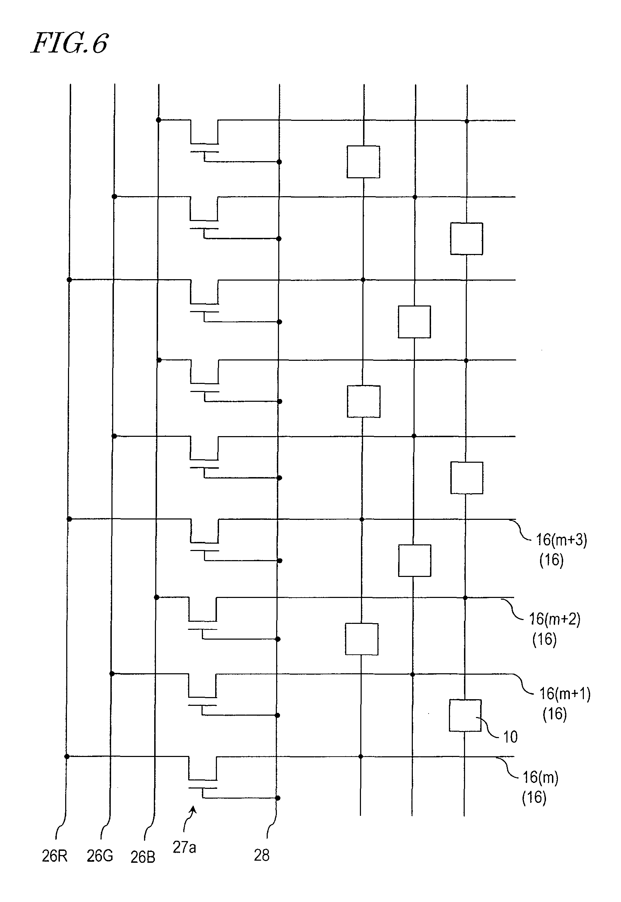

FIG. **6** is an equivalent circuit diagram describing test signal lines. As shown in FIG. **6**, three test signal lines **26R, 26G,** and **26B,** test TFTs **27a,** and a control signal line for testing **28** are provided in the semiconductor device **100,** for example. Each of the test signal lines **26R, 26G,** and **26B** is electrically connected to the drain electrodes of test TFTs **27a,** for example. Furthermore, each source line **16** (**16(m)** to **16(m+3)**) is electrically connected to the source electrode of a test TFT **27a,** for example. The gate electrodes of the test TFTs **27a** are electrically connected to the control signal line for testing **28** for controlling the test TFTs **27a**. A diode element **10** is disposed between source lines **16(m)** and **16(m+3)** connected to the test TFTs **27a** that are electrically connected to the same test signal line **26R, 26G,** or **26B,** for example, and connected to the source line **16(m)** and the source line **16(m+3).**

The graph shown in FIG. **1(b)** is a graph showing the voltage (V)-current (I) characteristics of the diode element **10**.

As shown in FIG. **1 (b)**, the diode elements **10** have a varistor current of between 20 V and 400 V. When a voltage which is equal to or less than the varistor current is applied to the semiconductor layer of a diode element **10**, no current flows in the diode element **10**; thus, there is insulation between the source line **16(m)** and the source line **16(m+1)**. When a voltage exceeding the varistor current is applied to the semiconductor layer of a diode element **10**, a current flows in the diode element **10**; thus, there is electrical connection between the source line **16(m)** and the source line **16(m+1)**.

Although not shown, a diode element for a short-circuit ring may be formed between two adjacent gate lines (e.g. gate lines **14(n)** and **14(n+1)**). Furthermore, a diode element for a short-circuit ring may be formed between a gate line **14** and a source line **16**, so as to connect the short-circuit ring for the source lines and the short-circuit ring for the gate lines.

In the semiconductor device **100**, when external static electricity enters any source line **16** (or/and any gate line **14**), the gates of the diode elements **10A** and **10B** that are electrically connected to the source line **16** (or/and gate line **14**) open, so that charge is consecutively diffuse toward an adjacent source line **16** (or/and a gate line **14**). As a result, all source lines **16** (or/and gate lines **14**) become equipotential, whereby the thin film transistors **50** can be prevented from being damaged by the static electricity.

FIG. **2** is a diagram describing diode elements **10** (**10A** and **10B**) for short-circuit rings. FIG. **2(a)** is a schematic plan view of the diode elements **10**, whereas FIG. **2(b)** is a cross-sectional view along line **I-I'** in FIG. **2(a)**.

As shown in FIG. **2(a)** and FIG. **2(b)**, each diode element **10** includes: a first electrode **3** (**3a** or **3b**) which is made of the same electrically conductive film as the gate electrodes of the thin film transistors (e.g. pixel TFTs) **50** (not shown) that are formed on the insulative substrate **1**; a first insulating layer **4** formed on the first electrode **3**; an oxide semiconductor layer **5** (**5a** or **5b**) which is formed on the first insulating layer **4** and made of the same oxide semiconductor film as the oxide semiconductor layer of the thin film transistors **50**; and a second electrode **6** and a third electrode **7** which are in contact with the oxide semiconductor layer **5** and made of the same electrically conductive film as the source electrodes of the thin film transistors **50**. In the oxide semiconductor layer **5**, an offset region **19** is each formed between a first electrode **3** and the second electrode **6** and between a first electrode **3** and the third electrode **7**. When viewed from the normal direction of the insulative substrate **1**, the offset regions **19** do not overlap with the first electrodes **3**. Furthermore, when viewed from the normal direction of the insulative substrate **1**, it is preferable that the offset regions **19** overlap neither the first electrodes **3**, the second electrode **6**, nor the third electrode **7**. The second electrode **6** is electrically connected to the source line **16(m)**, whereas the third electrode **7** is electrically connected to the source line **16(m+1)**. Moreover, the first electrode **3a** of the diode element **10A** is electrically connected to the second electrode **6** via a transparent electrode **11**. The first electrode **3b** of the diode element **10B** is electrically connected to the third electrode **7** via a transparent electrode **11**.

Furthermore, a second insulating layer **8** is formed so as to cover the oxide semiconductor layer **5**, and a photosensitive organic insulating layer **9** is formed on the second insulating layer **8**. Moreover, an etch stopper layer may be formed on the oxide semiconductor layer **5**. There may be cases where the organic insulating layer **9** does not need to be formed.

Each diode elements **10** has a channel length **L** of e. g. 30 µm and a channel width **W** of e. g. 5 µm; and its width (offset region width) **W'** along a direction which is parallel to the channel direction of the offset region **19** is e.g. 3 µm. Moreover, the channel length **L** is preferably between e.g. 10 µ m and 50 µm; the channel width **W** is preferably between e.g. 2 µm and 10 µm; and the offset region width **W'** is preferably between 1.5 µm and 5 µm. By choosing such a channel length **L**, channel width **W**, and offset region width **W'**, it is ensured that the diode elements **10** function as diode elements for short-circuit rings having the aforementioned characteristics.

The first electrodes **3**, the second electrode **6**, the third electrode **7**, the gate lines **14**, and the source lines **16** have a multilayer structure with an lower layer of Ti (titanium) and an upper layer of Cu (copper), for example. The lower layer has a thickness of e.g. 30 nm to 150 nm. The upper layer has a thickness of e.g. 200 nm to 500 nm. Moreover, for example, the upper layer may be an Al (aluminum) layer instead of a Cu layer, and the first electrodes **3**, the second electrode **6**, the third electrode **7** and the source lines **16** may have a single-layer structure of a Ti layer alone, for example.

The first insulating layer **4** and the second insulating layer **8** have a single-layer structure containing SiNₓ (silicon nitride), for example. The first insulating layer **4** and the second insulating layer **8** each have a thickness of e.g. 100 nm to 500 nm.

The oxide semiconductor layer **5** is an oxide semiconductor layer containing at least one of In (indium), Ga (gallium), and Zn (zinc) elements, for example. In the present embodiment, the oxide semiconductor layer **5** is an amorphous oxide semiconductor layer (a-IGZO layer) containing In, Ga, and Zn. The oxide semiconductor layer **5** has a thickness of e.g. 20 nm to 200 nm.

The organic insulating layer **9** has a thickness of e.g. 3 µm.

The transparent electrode **11** is made of e.g. ITO (Indium Tin Oxide). The transparent electrode **11** has a thickness of e.g. 50 nm to 200 nm.

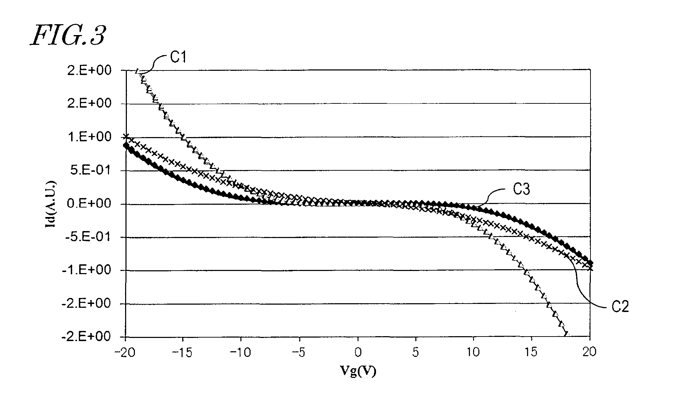

Next, with reference to FIG. **3**, the electrical characteristics of the diode element **10** will be described. FIG. **3** is a graph showing the voltage (V)-current (I) characteristics of the following elements. In FIG. **3**, curve **C1** is a curve representing the gate voltage (V)-current (I) characteristics of an oxide-semiconductor pixel TFT, which the semiconductor device **100** includes. Curve **C2** is a curve representing the voltage (V)-current (I) characteristics of the diode element **10**. Curve **C3** is a curve representing the voltage (V)-current (I) characteristics of a commonly-used diode element for a short-circuit ring (a-Si diode element), having an amorphous silicon (a-Si) layer as its semiconductor layer.

As can be seen from FIG. **3**, as the absolute value of the applied voltage increases, a pixel TFT will have the resistance value of its oxide semiconductor layer reduced, thus resulting in a current value with a large absolute value. In other words, because an oxide semiconductor layer has high mobility, it is difficult to adjust the resistance value of the semiconductor layer to several M Ω to several hundred M Ω under a high applied voltage. Therefore, a diode element having the construction of a pixel TFT is difficult to function as a diode element for a short-circuit ring. On the other hand, a comparison between the electrical characteristics of the diode element **10** and the electrical characteristics of the a-Si diode element indicates that curve **C2** and curve **C3** are substantially identical, i.e., the diode element **10** can function as a diode element for a short-circuit ring. This is because the diode element **10** has the offset regions **19** and the electrical resistance of the oxide semiconductor layer **5** of the diode element **10** is increased.

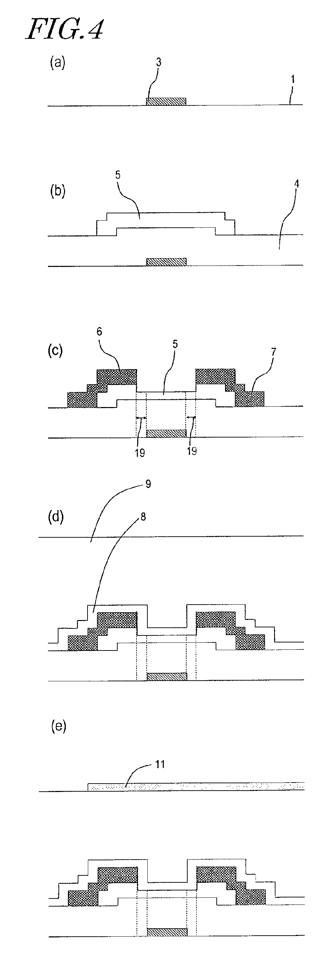

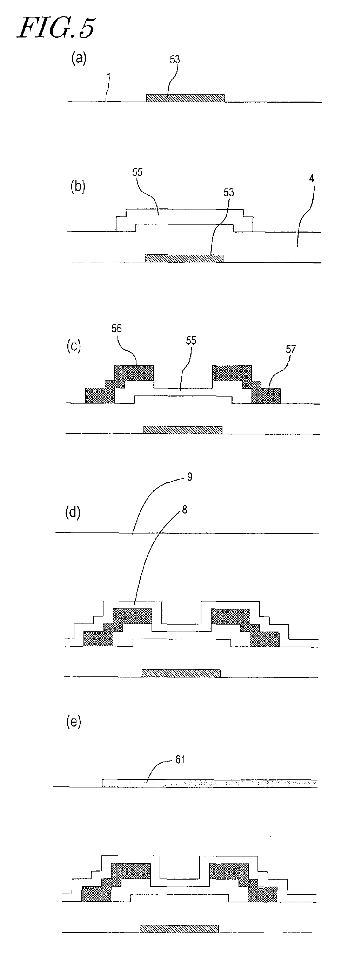

Next, a production method of the semiconductor device **100** according to an embodiment of the present invention will be described with reference to FIG. **4** and FIG. **5**. FIG. **4** is a diagram describing the production method of the diode element **10**, and FIG. **5** is a diagram describing the production method of the pixel TFT. The diode element **10** and the pixel TFT are to be formed through one series of processes. Note that the production method of the semiconductor device **100** is not limited to the method described below. For example, a semiconductor device production method which is disclosed in International Publication No. 2012/011258 may be used to form the diode element **10**. The entire disclosure of International Publication No. 2012/011258 is incorporated herein by reference.

First, the production method of the diode element **10** is described.

As shown in FIG. **4(a)**, on an insulative substrate (e.g. a glass substrate) **1**, a first electrode **3** having a multilayer structure with a lower layer of Ti and an upper layer of Cu is formed by a known method. The first electrode **3** is made of the same electrically conductive film as a gate electrode **53** of a pixel TFT, which is mentioned later. The lower layer of the first electrode **3** has a thickness of e.g. 30 nm to 150 nm. The upper layer of the first electrode **3** has a thickness of e.g. 200 nm to 500 nm. The upper layer may be e.g. an Al layer instead of a Cu layer, and the first electrode **3** may have a single-layer structure of e.g. a Ti layer alone.

Next, as shown in FIG. **4(b)**, on the first electrode **3**, a first insulating layer **4** containing e.g. SiNₓ is formed by a known method. The first insulating layer **4** has a thickness of e.g. 100 nm to 500 nm.

Next, an oxide semiconductor film is formed on the first insulating layer **4** by a known method. The oxide semiconductor film is made of an a-IGZO film, for example. The oxide semiconductor film is made of a semiconductor film which composes the semiconductor layer of the pixel TFT. The oxide semiconductor film has a thickness of e.g. 50 nm to 300 nm.

Next, the oxide semiconductor film is patterned by a known method, thus forming an oxide semiconductor layer **5**.

Next, on the oxide semiconductor layer **5**, an electrically conductive film having a multilayer structure with a lower layer of Ti and an upper layer of Cu is formed by a known method. The electrically conductive film is made of the same electrically conductive film as the source electrode **56** of the pixel TFT mentioned later. The upper layer may be e.g. an Al layer instead of a Cu layer, and the electrically conductive film may have a single-layer structure of e.g. a Ti layer alone. The lower layer has a thickness of e.g. 30 nm to 150 nm. The upper layer has a thickness of e.g. 200 nm to 500 nm.

Next, as shown in FIG. **4(c)****,** the electrically conductive film is patterned by a known method to form a second electrode **6** and a third electrode **7.** At this time, offset regions **19** are also formed. The offset regions **19** are formed so that, when viewed from the normal direction of the insulative substrate **1,** they overlap neither the first electrode **3,** the second electrode **6,** nor the third electrode **7**.

Next, as shown in FIG. **4(d)****,** a second insulating layer 8 is formed on the second and third electrodes **6** and **7** by a known method. The second insulating layer **8** is made of e.g. SiNₓ (silicon nitride). For example, the second insulating layer **8** has a thickness of e.g. 100 nm to 500 nm.

Next, a photosensitive organic insulating layer **9** is formed on the second insulating layer **8** by a known method. The organic insulating layer **9** is made of a photosensitive acrylic resin, for example. The organic insulating layer 9 has a thickness of e.g. 3 µm.

Next, as shown in FIG. **4 (e)****,** a transparent electrode **11** is formed on the organic insulating layer **9** by a known method. The transparent electrode **11** is made of ITO, for example. The transparent electrode **11** has a thickness of e.g. 50 nm to 200 nm. By forming the transparent electrode **11,** as shown in FIG. **2(a)****,** the first electrode **3** is electrically connected to the second electrode **6** or the third electrode **7** within a contact hole which is formed in the second insulating layer **8** and the organic insulating layer **9.**

Next, with reference to FIG. **5(a)** to FIG. **5(e)****,** the production method of the pixel TFT will be described.

As shown in FIG. **5(a)****,** on an insulative substrate (e.g. a glass substrate) **1,** a gate electrode **53** having a multilayer structure with a lower layer of Ti and an upper layer of '.Cu is formed by a known method. The gate electrode **53** is sized larger than the first electrode 3.

Next, as shown in FIG. **5(b)****,** on the gate electrode **53,** a first insulating layer **4** containing e.g. SiNₓ is formed by a known method. The first insulating layer **4** has a thickness of e.g. 100 nm to 500 nm.

Next, an oxide semiconductor film is formed on the first insulating layer **4** by a known method. The oxide semiconductor film is made of an a-IGZO film, for example. The oxide semiconductor film has a thickness of e.g. 50 nm to 300 nm.

Next, the oxide semiconductor film is patterned by a known method, thus forming an oxide semiconductor layer **55**.

Next, on the oxide semiconductor layer **55**, an electrically conductive film having a multilayer structure with a lower layer of Ti and an upper layer of Cu is formed by a known method. The upper layer may be e.g. an Al layer instead of a Cu layer, and the electrically conductive film may have a single-layer structure of e.g. a Ti layer alone. The lower layer has a thickness of e.g. 30 nm to 150 nm. The upper layer has a thickness of e.g. 200 nm to 500 nm.

Next, as shown in FIG. **5(c)****,** the electrically conductive film is patterned by a known method, thus forming a source electrode **56** and a drain electrode **57**. Since the gate electrode **53** is formed to be larger than the first electrode **3**, the aforementioned offset regions **19** are not formed.

Next, as shown in FIG. **5(d)****,** a second insulating layer **8** is formed on the source electrode **56** and the drain electrode **57** by a known method. The second insulating layer **8** is made of e.g. SiNₓ (silicon nitride). The second insulating layer **8** has a thickness of e.g. 100 nm to 500 nm.

Next, a photosensitive organic insulating layer **9** is formed on the second insulating layer **8** by a known method. The organic insulating layer **9** is made of a photosensitive acrylic resin, for example. The organic insulating layer **9** has a thickness of e.g. 3 µm.

1 Next, as shown in FIG. **5(e)**, a pixel electrode **61** is formed on the organic insulating layer **9** by a known method. The pixel electrode **61** is made of a transparent electrode, e.g., ITO. The pixel electrode **61** has a thickness of e.g. 50 nm to 200 nm.

Thus, the diode element **10** and the pixel TFT can be produced through fabrication processes at least some of whose steps are common steps. As a result, the semiconductor device **100** can be produced efficiently.

The semiconductor device according to an embodiment of the present invention and the production method thereof are not limited to the aforementioned examples, and encompass cases where static electricity prevention is desired.

Thus, according to the present invention, there is provided a production method of a semiconductor device having an oxide semiconductor TFT in which electrostatic damage is prevented, and a semiconductor device which is produced by that production method.

### INDUSTRIAL APPLICABILITY

The present invention is broadly applicable to semiconductor devices having a thin film transistor, including: circuit boards such as active matrix substrates; display devices such as liquid crystal display devices, organic electroluminescence (EL) display devices, and inorganic electroluminescence display devices; imaging devices such as image sensor devices; image input devices and fingerprint reading devices; and so on.

### REFERENCE SIGNS LIST

- **1**: insulative substrate
- **3, 3a, 3b**: first electrode
- **4, 8, 9**: insulating layer
- **5, 5a, 5b**: oxide semiconductor layer
- **6**: second electrode
- **7**: third electrode
- **10, 10A, 10B**: diode element
- **11**: transparent electrode
- **19**: offset region
- **100**: semiconductor device

## Claims

1. A semiconductor device comprising:
an insulative substrate;
a plurality of lines formed on the insulative substrate;
a plurality of thin film transistors; and
a plurality of diode elements each electrically connecting two of the plurality of lines to each other, wherein,
the plurality of diode elements each include
a first electrode made of a same electrically conductive film as gate electrodes of the thin film transistors,
an oxide semiconductor layer formed on the first electrode, and
a second electrode and a third electrode made of a same electrically conductive film as source electrodes of the thin film transistors, the second electrode and the third electrode being in contact with the oxide semiconductor layer; and
the oxide semiconductor layer has offset regions respectively between the first electrode and the second electrode and between the first electrode and the third electrode, the offset regions not overlapping the first electrode when viewed from a normal direction of the insulative substrate.

2. The semiconductor device of claim 1, wherein the offset regions overlap neither the first, second, nor third electrode when viewed from the normal direction of the insulative substrate.

3. The semiconductor device of claim 1 or 2, wherein a width of the offset regions along a direction which is parallel to a channel direction is not less than 3 µm and not more than 5 µm.

4. The semiconductor device of any of claims 1 to 3, wherein the plurality of diode elements are in parallel electrical connection, the diode elements being in mutually opposite directions.

5. The semiconductor device of any of claims 1 to 4, wherein the oxide semiconductor layer contains at least one of In, Ga, and Zn.

6. The semiconductor device of any of claims 1 to 5, wherein,
the plurality of lines include a plurality of source lines and a plurality of gate lines; and
the plurality of diode elements include at least one of:
a diode element electrically connecting two source lines to each other; and a diode element electrically connecting two gate lines to each other.

7. The semiconductor device of any of claims 1 to 6, wherein,
the plurality of lines further include a plurality of storage capacitor lines, a common electrode line, or a plurality of test signal lines; and
the plurality of diode elements include: a diode element electrically connecting two source lines to each other; a diode element electrically connecting two gate lines to each other; a diode element electrically connecting a gate line and a storage capacitor line to each other; a diode element electrically connecting a source line and a storage capacitor line to each other; a diode element electrically connecting a storage capacitor line and the common electrode line to each other; a diode element electrically connecting a gate line and the common electrode line to each other; a diode element electrically connecting a source line and the common electrode line to each other; or a diode element electrically connecting two test signal lines to each other.

8. A display device comprising the semiconductor device of any of claims 1 to 7.
